# EUROPEAN PATENT APPLICATION

(11) **EP 3 730 832 A1**
(43) Date of publication of application: **28.10.2020**
(21) Application number: 19201364.7
(22) Date of filing: 03.10.2019
(51) Int. Cl.: F21K 9/278, F21V 29/70, F21K 9/272, F21V 23/00, F21V 29/87, F21V 29/89, F21Y 103/10, F21Y 115/10, H05K 1/02

(54) **LED TUBE**

(30) Priority: 26.04.2019 US 201916396425
(71) Applicant: BGT Materials Limited, Manchester M13 9PL (GB)
(72) Inventor: CHANG, KUO-HSIN, DALIN TOWNSHIP CHIAYI COUNTY 622 (TW); LAI, CHUNG-PING, 302 ZHUBEI CITY (TW)
(74) Representative: Cabinet Chaillot

(57) **Abstract**

LED tube comprising: a tubular body (20) with two hollow end caps (21), each having two pins (210) , an LED driver (30) accommodated in one of the two hollow caps (21) and electrically connected with the pins (210) , and a fixing member (40) including a substrate (41) with a first and second face (411, 412) , and at least one light emitting diode (42) mounted on the first face (411) and electrically connected with the LED driver (30) via a conductive element (43) on the first face (411). The second face (412) has a conductive metal (44) communicating with the conductive element (43). Heat-conduction-dissipation glue (50) is applied on the second face (412) and the conductive metal (44), the conductive metal (44) contacts with the heat-conduction-dissipation glue (50) directly, and the fixing member (40) is adhered on the body (20) via the heat-conduction-dissipation glue (50).

## Description

### FIELD OF THE INVENTION

The present invention relates to an LED tube which dissipates heat and reduces production cost greatly.

### BACKGROUND OF THE INVENTION

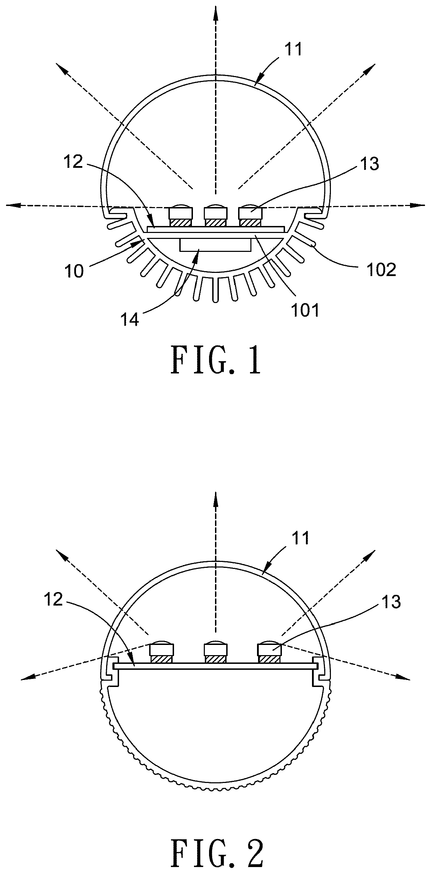

Referring to FIG. 1, a conventional LED tube contains a semicircular housing 10 made of aluminum, a PC transparent cover 11, and a PCB fixing member 12.

The PCB fixing member 12 includes multiple light emitting diodes configured to illuminate lights through the PC transparent cover 11. The conventional LED tube further contains a driver configured to drive the multiple light emitting diodes to illuminate the lights and separated from the PCB fixing member 12. A back face of the PCB fixing member 12 is adhered on a support face 101 of the semicircular housing 10 via conductive glue, heat conducts to the semicircular housing 10 from the PCB fixing member 12 via the conductive glue, and the semicircular housing 10 and multiple dissipation fins 102 of the back face of the semicircular housing 10 dissipate the heat, wherein a hollow chamber is defined between the support face 101 and the back face of the semicircular housing 10 so as to accommodate the driver 14. Because the hollow chamber is defined between the support face 101 and the back face of the semicircular housing 10, the PCB fixing member 12 is close to a center of a cross section of the LED tube, thus increasing a dark zone on the back face of the LED tube and decreasing illumination angle.

Referring to FIG. 2, another conventional LED tube contains a driver configured to drive multiple light emitting diodes 13 and a PCB fixing member 12 connected with the driver, wherein this conventional LED tube does not dissipate heat by using a housing 10 which is not made of aluminum, thus reducing heat dissipation.

The present invention has arisen to mitigate and/or obviate the afore-described disadvantages.

### SUMMARY OF THE INVENTION

The primary objective of the present invention is to provide an LED tube which dissipates heat and reduces production cost greatly.

To obtain above-mentioned objectives, an LED tube provided by the present invention contains: a body, an LED driver, and a fixing member.

The body is tubular and is light transmissive, the body includes two hollow caps mounted on two ends of the body respectively, and each of the two hollow caps has two opposite pins extending to the body from each hollow cap.

The LED driver is accommodated in one of the two hollow caps and is electrically connected with the two opposite pins of the one hollow cap.

The fixing member includes a substrate, at least one light emitting diode, and a conductive element. The substrate has a first face and a second face opposite to the first face, and the at least one light emitting diode is mounted on the first face of the substrate and is electrically connected with the LED driver via the conductive element. The second face of the substrate has a conductive metal communicating with the conductive element of the first face so that heat conducts to the conductive metal of the second face of the substrate from the at least one light emitting diode via the conductive element of the first face.

Heat-conduction-dissipation glue is applied on the second face and the conductive metal, the conductive metal contacts with the heat-conduction-dissipation glue directly, and the fixing member is adhered on an inner surface of the body via the heat-conduction-dissipation glue.

### BRIEF DESCRIPTION OF THE DRAWINGS

FIG. 1 is a cross sectional view of a conventional LED tube.
FIG. 2 is a cross sectional view of another conventional LED tube.
FIG. 3 is a perspective view showing the assembly of an LED tube according to a first embodiment of the present invention.
FIG. 4 is a perspective view showing the exploded components of the LED tube according to the first embodiment of the present invention.
FIG. 5 is a cross sectional view taken along the line A-A of FIG. 3.
FIG. 6 is a cross sectional view showing the assembly of an LED tube according to a second embodiment of the present invention.
FIG. 7 is a cross sectional view showing the assembly of an LED tube according to a third embodiment of the present invention.
FIG. 8 is a cross sectional view showing the assembly of an LED tube according to a fourth embodiment of the present invention.

### DETAILED DESCRIPTION OF THE PREFERRED EMBODIMENTS

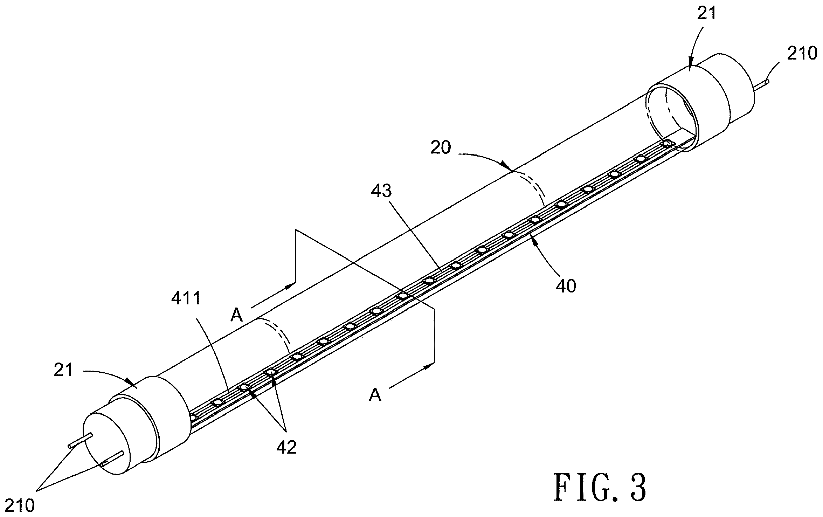

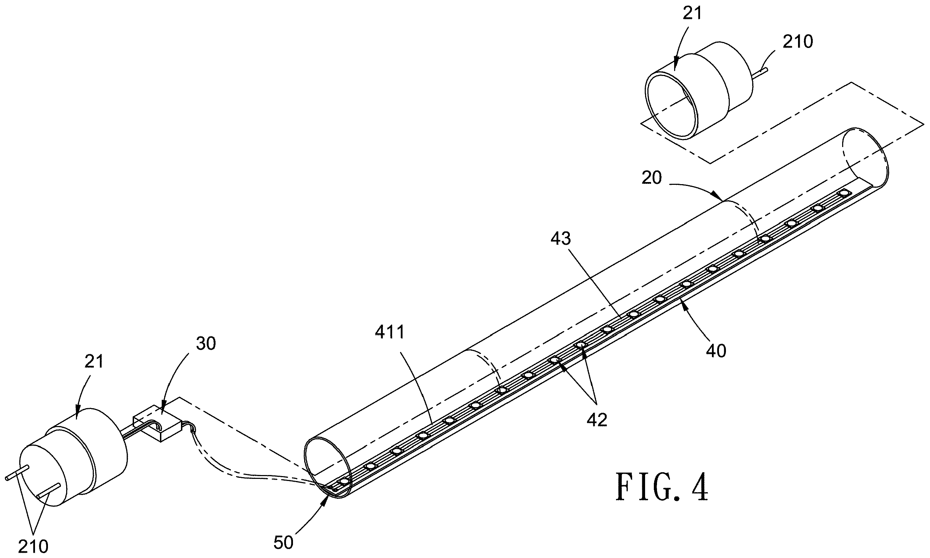

With reference to FIGS. 3 and 4, a light-emitting diode (LED) tube according to a first embodiment of the present invention comprises: a body 20, an LED driver 30, and at least one LED fixing member 40.

The body 20 is tubular and is light transmissive, wherein the body 20 is made of any one of transparent glass, transparent plastic, creamy white glass, creamy white plastic, and porous plastic. The body 20 includes two hollow caps 21 mounted on two ends thereof respectively, and each of the two hollow caps 21 has two opposite pins 210 extending to the body 20 from each hollow cap 21 so as to match with a socket (not shown).

The LED tube is removably and electrically connected with a power supply, wherein the LED driver 30 is accommodated in one of the two hollow caps 21 and is electrically connected with the two opposite pins 210 of the one hollow cap 21.

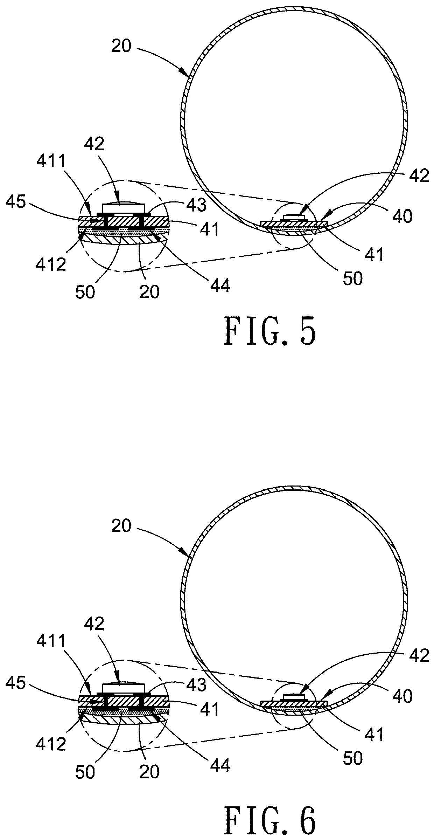

The fixing member 40 includes a substrate 41, at least one light emitting diode 42, and a conductive element 43 which is at least one conductive wire. The substrate 41 has a first face 411 and a second face 412 opposite to the first face 411 (as shown in FIG. 5), the at least one light emitting diode 42 is mounted on the first face 411 of the substrate 41 and is electrically connected with the LED driver 30 via the at least one conductive wire 43. For example, the at least one light emitting diode 42 is electrically connected with the at least one conductive wire 43 in a welding manner or by using conductive silver glue, and the at least one LED light emitting diode 42 is electrically connected with the LED driver 30 via the at least one conductive wire 43. The LED driver 30 is electrically connected with the power supply by ways of the two opposite pins 210 of the one hollow cap 21 and the socket (not shown), and the LED driver 30 converts power of the power supply into driving power configured to drive the at least one light emitting diode 42 to illuminate lights.

The second face 412 of the substrate 41 has a conductive metal 44 communicating with the at least one conductive wire 43 of the first face 411 so that heat conducts to the conductive metal 44 of the second face 412 of the substrate 42 from the at least one light emitting diode 42 via the at least one conductive wire 43 of the first face 411, wherein heat-conduction-dissipation glue 50 is applied on the second face 412 and the conductive metal 44, the conductive metal 44 contacts with the heat-conduction-dissipation glue 50 directly, and the fixing member 40 is adhered on an inner surface of the body 20 via the heat-conduction-dissipation glue 50, as shown in FIG. 5. For example, the fixing member 40 is adhered on the body 20 directly via the heat-conduction-dissipation glue 50, the heat conducts to the heat-conduction-dissipation glue 50 from the at least one light emitting diode 42 via the at least one conductive wire 43 and the conductive metal 44 and further transmits to body 20 so that the heat is dissipated from the body 20. Since the fixing member 40 and the at least one light emitting diode 42 are close to the inner surface of the body 20, a dark zone of the at least one light emitting diode 42 in a back surface of the fixing member 40 reduces.

Referring to FIG. 5, the fixing member 40 is a printed circuit board (PCB) on which the substrate 41 and the at least one conductive wire 43 are arranged. A part of the at least one conductive wire 43 of the first face 411 of the PCB is in communication with the conductive metal 44 of the second face 412 via multiple through orifices of the PCB. For instance, the part of the at least one conductive wire 43 of the first face 411 of the PCB is in communication with the conductive metal 44 of the second face 412 via the multiple through orifices 45 of the PCB, wherein the conductive metal 44 contacts with the heat-conduction-dissipation glue 50 directly.

As illustrated in FIG. 6, in a second embodiment, a substrate 41 is a ceramics substrate, and at least one conductive wire 43 is made of any one of conductive silver glue, conductive copper glue, conductive carbon glue, and graphene glue in a printing manner. A part of the at least one conductive wire 43 of a first face 411 of the ceramics substrate 41 is in communication with a conductive metal 44 of a second face 412 via multiple through orifices 45 of the ceramics substrate, wherein the conductive metal 44 contacts with heat-conduction-dissipation glue 50 directly.

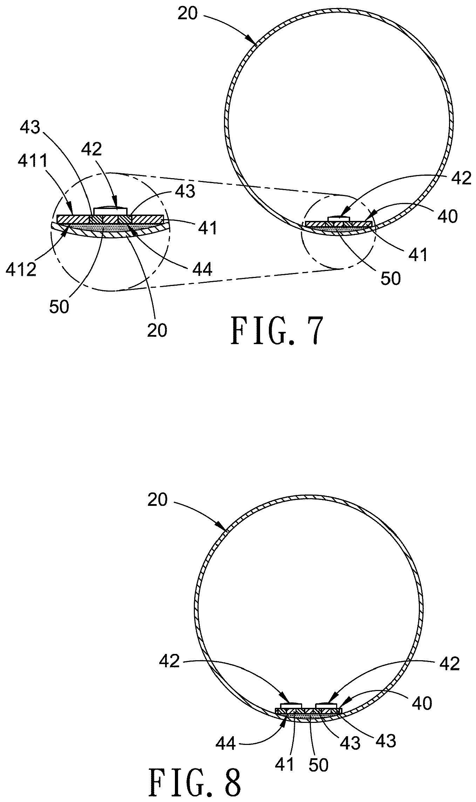

With reference to FIG. 7, in a third embodiment, a conductive element 43 is a metal sheet and is connected with a substrate 41 in an injection molding manner, wherein the substrate 41 is made of plastic. In this embodiment, the metal sheet 43 is used as the conductive metal 44 extending to a second face 412 of the substrate 41 and contacts with heat-conduction-dissipation glue 50 directly, wherein the metal sheet 43 is cut, is injection molded and is fixed by using plastic. The metal sheet 43 is connected with plastic so as to produce the substrate 41, the metal sheet 43, and the conductive metal 44. A heat conducts to heat-conduction-dissipation glue 50 from at least one light emitting diode 42 via the metal sheet 43.

The at least one light emitting diode 42 is mounted by face-up chip bonding or by flip-chip bonding.

For example, when the fixing member 40 is the printed circuit board (PCB), the at least one light emitting diode 42 is mounted on the first face 411 of the substrate 41 of the PCB by face-up chip bonding. Referring to FIG. 6, when the substrate 41 is the ceramics substrate, the at least one light emitting diode 42 is mounted on the first face 411 of the ceramics substrate 41 by the flip-chip bonding. As shown in FIG. 7, when the conductive element 43 is the metal sheet, the at least one light emitting diode 42 is mounted on the first face 411 of the substrate 41 by the flip-chip bonding.

As illustrated in FIG. 7, multiple light emitting diodes 42 are mounted on the first face 411 of the substrate 41 in a single-row/column arrangement or in a multiple-rows/columns arrangement (as shown in FIG. 8), wherein the multiple light emitting diodes 42 are mounted in the multiple rows arrangement and have different color temperatures which are adjustable by ways of the LED driver 30.

The heat-conduction-dissipation glue 50 is made of dissipation fillers, dispersants, and binders.

The dissipation fillers are any one of carbon materials, metal particles, metal particles, ceramic materials, infrared-ray radiation powders, and up conversion materials or a combination of at least two of the carbon materials, the metal particles, the metal particles, the ceramic materials, the infrared-ray radiation powders, and the up conversion materials.

The carbon materials consist of any one of graphene, carbon black, graphite, carbon nanotubes, and activated carbon or a combination of at least two of the graphene, the carbon black, the graphite, the carbon nanotubes, and the activated carbon.

The metal particles consist of any one of copper (Cu), aluminum (Al), nickel (Ni), zinc (Zn), iron (Fe), cobalt (Co), silver (Ag), aurum (Au), platinum (Pt), alloy of at least two of Cu, Al, Ni, Zn, Fe, Co, Ag, Au and Pt, and a combination of at least two of Cu, Al, Ni, Zn, Fe, Co, Ag, Au and Pt.

The infrared-ray radiation powders consist of any one of cerium oxide (SiO2), alumina (Al2O3), titanium dioxide (TiO2), zirconium oxide (ZrO2), zirconium carbide (ZrC), silicon carbide (SiC), tantalum carbide (TaC), titanium diboride (TiB2), zirconium diboride (ZrB2), titanium disilicide (TiSi2), silicon nitride (Si3N4), titanium nitride (TiN) and boron nitride (BN) or a combination of at least two of SiO2, Al2O3, TiO2, ZrO2, ZrC, SiC, TaC, TiB2, ZrB2, TiSi2, Si3N4, TiN and BN.

The up conversion materials are any one of fluorinated arsenic chloride-based glass, oxyfluoride glass (Al2O3, CdF2, PbF2, YF3), ZBLAN glass (Nd3Pb5M3F19 : M=Al, Ti, V , Cr, Fe ,Ga ; Ho3 BaY2F8; Pr3K2YF5), AlF3-based glass, highly doped (ErF3) in the alumina yttrium floride system, (alumina zirconium floride) highly doped (Er3) in glass system, Er3Cs3Lu2Br9 glass, GGSX (Pr3GeS2Ga2S3CsCl) glass, PGPNO (Pr3GeO2PbONb2O5) glass, Er3TeO glass, La2S3 glass, phosphate glass, Fluoro-Boric acid salt glass, and tellurium acid salt glass or a combination of at least two of fluorinated arsenic chloride-based glass, oxyfluoride glass (Al2O3, CdF2, PbF2, YF3), ZBLAN glass (Nd3Pb5M3F19 : M=Al , Ti , V , Cr , Fe ,Ga ;Ho3 BaY2F8; Pr3K2YF5), AlF3-based glass, highly doped (ErF3) in the alumina yttrium floride system, (alumina zirconium floride) highly doped (Er3) in glass system, Er3Cs3Lu2Br9 glass, GGSX (Pr3GeS2Ga2S3CsCl) glass, PGPNO (Pr3GeO2PbONb2O5) glass, Er3TeO glass, La2S3 glass, phosphate glass, Fluoro-Boric acid salt glass, and tellurium acid salt glass.

While the preferred embodiments of the invention have been set forth for the purpose of disclosure, modifications of the disclosed embodiments of the invention as well as other embodiments thereof may occur to those skilled in the art. Accordingly, the appended claims are intended to cover all embodiments which do not depart from the spirit and scope of the invention.

## Claims

1. A light-emitting diode (LED) tube comprising:
a body (20) being tubular and being light transmissive, the body (20) including two hollow caps (21) mounted on two ends of the body (20) respectively, and each of the two hollow caps (21) having two opposite pins (210) extending to the body (20) from each hollow cap (21);
an LED driver (30) accommodated in one of the two hollow caps (21) and electrically connected with the two opposite pins (210) of the one hollow cap (21); and
a fixing member (40) including a substrate (41), at least one light emitting diode (42), and a conductive element (43);
**characterized in that**
the substrate (41) has a first face (411) and a second face (412) opposite to the first face (411), and the at least one light emitting diode (42) is mounted on the first face (411) of the substrate (41) and is electrically connected with the LED driver via the conductive element (43), the second face (412) of the substrate (41) has a conductive metal (44) communicating with the conductive element (43) of the first face (411) so that heat conducts to the conductive metal (44) of the second face (412) of the substrate (41) from the at least one light emitting diode (42) via the conductive element (43) of the first face (411);
heat-conduction-dissipation glue (50) is applied on the second face (412) and the conductive metal (44), the conductive metal (44) contacts with the heat-conduction-dissipation glue (50) directly, and the fixing member (40) is adhered on an inner surface of the body (20) via the heat-conduction-dissipation glue (50).

2. The LED tube as claimed in claim 1, **characterized in that** the conductive element (43) is at least one conductive wire.

3. The LED tube as claimed in claim 1, **characterized in that** the body (20) is made of any one of transparent glass, transparent plastic, creamy white glass, creamy white plastic, and porous plastic.

4. The LED tube as claimed in claim 1, **characterized in that** the conductive element (43) is a metal sheet and is connected with a substrate (41) in an injection molding manner, wherein the substrate (41) is made of plastic, the metal sheet is used as the conductive metal (44) extending to a second face (412) of the substrate (41) and contacts with heat-conduction-dissipation glue (50) directly.

5. The LED tube as claimed in claim 2, **characterized in that** the fixing member (40) is a printed circuit board (PCB) on which the substrate (41) and the at least one conductive wire are arranged, and a part of the at least one conductive wire of the first face (411) of the PCB is in communication with the conductive metal (44) of the second face (412) via multiple through orifices (45) of the PCB.

6. The LED tube as claimed in claim 1, **characterized in that** the substrate (41) is a ceramics substrate, and the conductive element (43) is at least one conductive wire made of any one of conductive silver glue, conductive copper glue, conductive carbon glue, and graphene glue, wherein a part of the at least one conductive wire of the first face (411) of the ceramics substrate is in communication with a conductive metal (44) of the second face (412) via multiple through orifices (45) of the ceramics substrate.

7. The LED tube as claimed in claim 1, **characterized in that** the at least one light emitting diode (42) is mounted by face-up chip bonding or by flip-chip bonding.

8. The LED tube as claimed in claim 1, **characterized in that** the heat-conduction-dissipation glue (50) is made of dissipation fillers, dispersants, and binders.

9. The LED tube as claimed in claim 8, **characterized in that** the dissipation fillers are any one of carbon materials, metal particles, metal particles, ceramic materials, infrared-ray radiation powders, and up conversion materials or a combination of at least two of the carbon materials, the metal particles, the metal particles, the ceramic materials, the infrared-ray radiation powders, and the up conversion materials.

10. The LED tube as claimed in claim 9, **characterized in that** the carbon materials consist of any one of graphene, carbon black, graphite, carbon nanotubes, and activated carbon or a combination of at least two of the graphene, the carbon black, the graphite, the carbon nanotubes, and the activated carbon.

11. The LED tube as claimed in claim 9, **characterized in that** the metal particles consist of any one of copper (Cu), aluminum (Al), nickel (Ni), zinc (Zn), iron (Fe), cobalt (Co), silver (Ag), aurum (Au), platinum (Pt), alloy of at least two of Cu, Al, Ni, Zn, Fe, Co, Ag, Au and Pt, and a combination of at least two of Cu, Al, Ni, Zn, Fe, Co, Ag, Au and Pt.

12. The LED tube as claimed in claim 9, **characterized in that** the infrared-ray radiation powders consist of any one of cerium oxide (SiO2), alumina (Al2O3), titanium dioxide (TiO2), zirconium oxide (ZrO2), zirconium carbide (ZrC), silicon carbide (SiC), tantalum carbide (TaC), titanium diboride (TiB2), zirconium diboride (ZrB2), titanium disilicide (TiSi2), silicon nitride (Si3N4), titanium nitride (TiN) and boron nitride (BN) or a combination of at least two of SiO2, Al2O3, TiO2, ZrO2, ZrC, SiC, TaC, TiB2, ZrB2, TiSi2, Si3N4, TiN and BN.
